(19) Europäisches Patentamt European Patent Office Office européen des brevets

(11) **EP 3 106 781 B1**

(12) **EUROPEAN PATENT SPECIFICATION**

(45) Date of publication and mention of the grant of the patent:
**01.12.2021 Bulletin 2021/48**

(51) Int Cl.:
*F25B 21/00* *(2006.01)*     *F25B 21/02* *(2006.01)*

(21) Application number: **15172694.0**

(22) Date of filing: **18.06.2015**

(54) **MAGNETOCALORIC DEVICE**

MAGNETOKALORISCHE VORRICHTUNG

DISPOSITIF MAGNÉTOCALORIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.12.2016 Bulletin 2016/51**

(73) Proprietor: **Gorenje gospodinjski aparati d.d. 3320 Velenje (SI)**

(72) Inventors:
• **KITANOVSKI, Andrej**
  **1000 Ljubljana (SI)**
• **JELENC, Bla**
  **1000 Ljubljana (SI)**

• **TOMC, Urban**
  **1261 Lj-Dobrunj (SI)**
• **POREDOS , Alojz**
  **1262 Dol pri Ljubljani (SI)**

(74) Representative: **Zacco GmbH**
  **Bayerstrasse 83**
  **80335 München (DE)**

(56) References cited:
  **WO-A1-2006/056809     WO-A1-2015/014853**
  **JP-A- 2014 228 216     US-A1- 2004 195 675**
  **US-A1- 2008 303 375     US-A1- 2011 215 088**
  **US-A1- 2014 216 057     US-B1- 6 588 216**

## Description

## Background of the Invention

The present invention relates to magnetocaloric devices for use in refrigeration, heat pump, or power generation applications.
WO 2015/014853 A1 discloses an electrocaloric cooling system which enables heat to be selectively transported from an electrocaloric material (ECM) towards a first stream of working fluid flowing towards a heat sink and from a second stream of working fluid towards the ECM flowing towards a heat source, whereby the first and second streams of working fluid are in counter flow. The ECM is used as an internal regenerator between the first and second streams of working fluid in order to generate large temperature differences between heat source and heat sink.

US 2014/216057 A1 discloses a heat generator with magnetocaloric material comprising at least one thermal flux generation unit provided with at least one thermal module containing a magnetocaloric element across which a heat transfer fluid circulates according to an alternating movement on both sides of the magnetocaloric element. The heat generator also comprises a magnetic arrangement to alternately subject the magnetocaloric element to a magnetic field variation and create alternately a heating cycle and a cooling cycle in the magnetocaloric element.

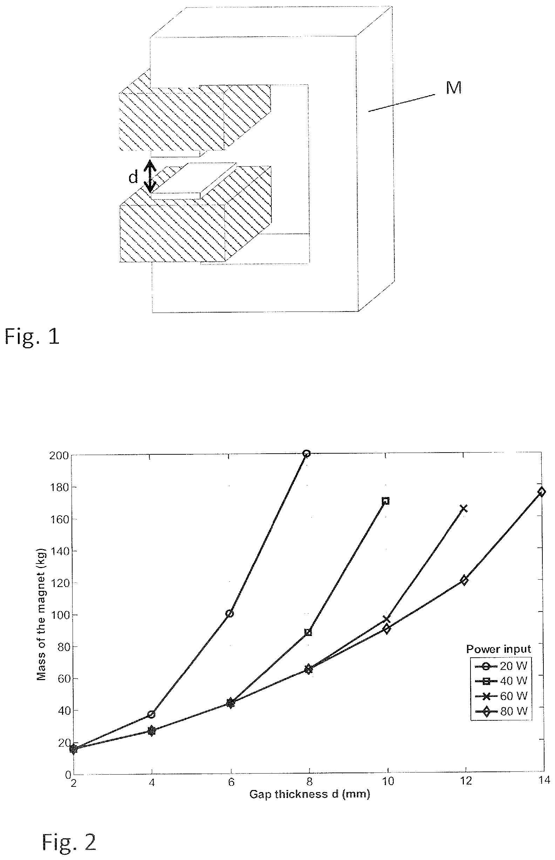

Fig. 1 shows a schematic illustration of a generic electric resistive magnet M. Therein, the thickness of the gap between the poles of the magnetic field is denoted with d. Now, for a fixed width and length of the gap, and for the fixed desired magnetic flux density of the gap one may calculate that the mass and the volume of the magnetic field increases with the order 3 with the increase of the thickness **d**.

Based on Figure 2, it can thus be concluded that the thickness of the gap should be as small as possible, while keeping minimum possible power input (since this defines the energy efficiency of the electric resistive magnetic field source). Therefore, it is better to perform several miniature magnetic field sources compared to a single magnetic field source with the larger thickness of the gap and with the occupation of the same volume. Of course, the miniaturization of the thickness of the magnetic field gap, e.g. below the range 1 to 5 mm, makes the active magnetic regenerator (AMR) principle or the magnetocaloric porous structure not applicable. Namely the AMR requires a porous structure of the magnetocaloric material with voids, and the manufacturability of magnetocaloric material (even with predicted improvements in future) will not be able to provide so fine structures (ordered structures, thickness of the magnetocaloric material below 50 microns with acceptable mechanical properties) or packed bed structures. In the latter, the small particles will also create very small voids with variable hydraulic diameter, which does not result in controlled fluid dynamics and heat transfer. Moreover, the pressure losses in such structures are becoming large. This strongly influences the efficiency of the device, especially if it has to operate with high number of thermodynamic cycles per unit of time (e.g. above 5 Hz), and simultaneously provide a predetermined temperature difference between the heat source and the heat sink.

It is thus an object of the present invention to provide an efficient magnetocaloric device.

## Summary

According to the present invention, a magnetocaloric device is defined in claim **1.**

According to embodiments, the heat transfer structures may comprise at least one thermal switch which is adapted to vary transfer or transport of the heat from the magnetocaloric material to the hydraulic circuit or from the hydraulic circuit to the magnetocaloric material. Thus, the direction of the heat transfer to and from the magnetocaloric material can be efficiently controlled using the at least one thermal switch.

According to further embodiments, the heat transfer structures may comprise at least one multifunctional coating which is adapted to affect the wetting effect of the working fluid, or/and to affect the thermal or velocity boundary layer of the working fluid, or/and to affect the chemical protection of the magnetocaloric material, and/or to affect the mechanical properties of the magnetocaloric material, and/or to affect the effective thermal properties of the magnetocaloric material and the multifunctional layer.

According to further embodiments, the heat transfer structures may comprise at least one means for time varying fluctuation of the heat transfer from the hydraulic circuit to the magnetocaloric material or for time varying fluctuation of the heat transfer from the magnetocaloric material to the hydraulic circuit, wherein the time varying fluctuation of the heat transfer may be provided by a time dependent variable fluid flow above and/or below the magnetocaloric material. Thus, the heat transfer between the magnetocaloric material and the hydraulic circuit may be controlled by the heat transfer structures such that, during a first time period, heat is transferred substantially only from the hydraulic circuit to the magnetocaloric material and that, after changing the heat transfer properties of the heat transfer structures, during a second time period, heat is transferred substantially only from the magnetocaloric material to the hydraulic circuit.

According to embodiments, the electric source may comprise electric windings, a core for the manipulation of the magnetic flux direction, and an electric circuit which enables the regeneration of magnetic energy.

The electric source may be adapted to perform a time dependent variation of increasing or decreasing magnetic field intensity in the range between 0.0001 to 5 seconds. Alternatively or additionally, the electric source may be adapted to perform a variation of the magnetic field intensity in the range between 0 to 40 Tesla. Thus, the electric source can provide e.g. a magnetic field intensity at high frequencies, so that the individual thermodynamic cycles of the magnetocaloric device are repeated at high frequencies in the range of 0.2 Hz — 1kHz.

According to embodiments, the magnetocaloric device may perform refrigeration, heat pumping or power generation by one of a magnetic Brayton, magnetic Stirling, magnetic Carnot, or magnetic Ericsson cycle.

According to embodiments, the magnetocaloric device may perform refrigeration, heat pump or power generation by non-conventional thermodynamic cycles, comprising a combination of magnetic isofield process(es), and/or magnetic isothermal magnetization or demagnetization, and/or magnetic isentropic or polytropic magnetization or demagnetization, and/or isomagnetization process(es).

According to embodiments, the hydraulic circuit with the working fluid may be connected to at least one heat exchanger, such as a heat source or/and a heat sink heat exchanger.

According to embodiments, the working fluid propulsion may be created by ionic, or magnetohydrodynamic, or magnetocaloric, or magnetorheologic, or ferrofluidic, or electrocaloric, or electrowetting, or electrophoeretic, or electrokinetic, or electrohydrodynamic principles.

According to embodiments, the working fluid propulsion may be created by at least one piston, or by at least one turbine, or at least one membrane, or at least one peristaltic mechanism, or at least one ejector principle, or at least one magnetohydrodynamic principle, or at least one electrohydrodynamic or electrokinetic principle, or at least one electrophoretic principle, or at least one electrowetting principle, or at least one ferrohydrodynamic principles, or at least one magnetorheologic principle.

The magnetocaloric material may be any material which exhibits the magnetocaloric effect in the range of temperature between 0 to 3000 K.

According to embodiments, a plurality of magnetocaloric materials may be used, each of which having a Curie temperature in the range between 0 to 3000 K.

According to embodiments, at least one or several magnetic field sources and several magnetocaloric materials may be present in order to provide an upgrade from the micro-scale to the macroscopic device for refrigeration or heat pumping, or power generation.

According to embodiments, the device may comprise at least one magnetic field source and a plurality of magnetocaloric materials, wherein each magnetocaloric material is embedded between two heat transfer structures, and wherein a common hydraulic circuit is provided such that the heat transfer structures are adapted to control the transfer or transport of heat between each magnetocaloric material and the working fluid.

Thus, a macro-scale magnetocaloric device can be provided by using a minimum of one, but rather a plurality of micro-scale assemblies comprising respective magnetocaloric material and heat transfer structures. Therein, the micro-scale assemblies may be combined with a common magnetic field source, such as e.g. a multi-pole magnetic field source, or may be provided with a plurality of magnetic field sources.

Moreover, in a special case, the magnetic field source can represent a combination of the electric coil, combined with permanent magnets.

According to embodiments, a plurality of magnetocaloric devices as described above may be combined to form a cascade system. A cascade system comprises a plurality of magnetocaloric devices, where in the case of refrigeration or heat pumping, the heat sink of the first device with lowest temperature represents heat source of the second stage, etc.

According to embodiments, a heat transfer structure comprising at least one thermal switch may be based on anisotropy of the thermal conductivity of the thermal switch material. Alternatively, the thermal switch may comprise at least one thermal switch composite material which exhibits anisotropy of the effective thermal conductivity. In this particular case, the anisotropy of the thermal conductivity of the thermal switch changes with external influences (e.g. temperature change, magnetic or electric means or others). The aim of such principle is that a thermal switch material or composite allows heat to flow in desired direction at the certain temperature, and prevents or decreases the rate of heat to flow in that direction at another temperature.

Alternatively, the thermal switch may be based on mechanical contact by elastomer materials, or liquid crystals, or on ferrofluids, or magnetorheologic principles, or liquid metals, or electrorheologic principles or magnetohydrodynamic principles or electrowetting, or electrophoeretic or electrokinetic or electrohydrodynamic principles. In this particular case, the thermal switch, being in the state of solid, suspension, or liquid, represents a thermal contact, which can be manipulated by electricity, magnetism, or thermal effects. When heat need to be removed from the magnetocaloric material, this kind of thermal switch absorbs heat from the magnetocaloric material (when this is in magnetized state), and by manipulation of in this paragraph mentioned mechanisms, changes its shape or position in order to perform a mechanical contact heat to the heat sink (vie e.g. the extended surface). When the magnetocaloric material is demagnetized (e.g. cold), the same thermal switch prevents heat to flow from the heat sink (e.g. via extended surface) to the magnetocaloric material. However, another thermal switch at this time provides a mechanical contact between the heat source (via another extended surface) and the magnetocaloric material.

As a further alternative, the thermal switch principle may be based on thermoelectric (Peltier or Seebeck), or thermionic, or spincaloritronic (spin Peltier or

**EP 3 106 781 B1**

spin Seebeck). Also in this case, as an example, the magnetocaloric material may be embedded between two thermal switches or e.g. its upper and lower surface. The thermal switch in this case may act as a heat pump which is on one side attached to the magnetocaloric material and on the other side attached to the extended surface. When the magnetocaloric material is magnetized, then the e.g. upper thermal switch is set on (e.g. by setting the electric current flow). Heat is ballistically transported from the magnetized magnetocaloric material to the extended surface. At the same time, the lower thermal switch is set off, thus preventing heat flow from the magnetocaloric material to the heat source (via the lower extended surface). When the magnetocaloric material is demagnetized, then the upper thermal switch is set off, and the lower thermal switch is set on, thus heat is pumped from the heat source (via the lower extended surface), to the magnetocaloric material.

According to the present invention, the electric source comprises an electromagnet and an energy collector device. The energy collector device is used for storing at least some of the energy ot the magnetic field of the electromagnet, and is further used to supply the stored energy to the electromagnet for generating a magnetic field in a subsequent operation cycle or operation phase of the device. Therein, the electric source is adapted to charge the energy collector device when the magnetic field of the electromagnet is turned off, and use the charged energy collector device for generation of a magnetic field in the electromagnet when the magnetic field is turned on.

According to the present invention, the electric source further comprises a first switching device for connecting the electromagnet to the energy collector device for charging the energy colletor device and a second switching device for connecting the energy collector device to the electromagnet for turning on the magnetic field in the electromagnet by releasing the energy stored in the energy collector device to start the current flow through the electromagnet.

According to embodiments, the energy collector device may comprise a battery or a capacitor. According to embodiments, the magnetic field may be generated by at least one electric source and

at least one permanent magnet material. Thus, a permanent magnet may be used for generation of the magnetic field for magnetizing the magnetocaloric material. Additionally, the electric circuit may enable regeneration of the magnetic energy in order to ensure a high energy efficiency of the magnetocaloric device.

**Brief description of the Drawings**

Embodiments of the invention will now be described with reference to the drawings, in which like reference numerals denote the same or corresponding elements, and in which:

Fig. 1 shows a schematic view of an electric resistive magnet;

Fig. 2 shows a diagram of the mass of a electric resistive magnet against the magnetic field gap thickness for producing a 1T magnetic field;

Fig. 3 shows a micro-magnetocaloric refrigerator or heat pump according to a first embodiment of the present invention;

Fig. 4 shows a micro-magnetocaloric power generator according to a second embodiment;

Fig. 5 shows a micro-magnetocaloric refrigerator or heat pump according to a third embodiment;

Fig. 6 shows a micro-magnetocaloric power generator according to a fourth embodiment;

Fig. 7 shows a micro-magnetocaloric refrigerator or heat pump according to a fifth embodiment;

Fig. 8 shows a micro-magnetocaloric power generator according to a sixth embodiment;

Fig. 9 shows a micro-magnetocaloric refrigerator or heat pump according to a seventh embodiment;

Fig. 10 shows a micro-magnetocaloric power generator according to an eighth embodiment;

Fig. 11 shows a schematic illustration of heat transfer between the magnetocaloric material and the working fluid;

Fig. 12 shows a multipole magnetic field source with multiple fluid channels in a cylindrical structure;

Fig. 13 shows an alternative embodiment which employs thermal switches;

Fig. 14 shows a further alternative embodiment which employs a multifunctional surface;

Fig. 15 shows a third alternative embodiment which employs thermal switches and multiple magnetocaloric materials and a magnetic field with several poles;

Fig. 16 shows a fourth alternative embodiment which employs multifunctional surfaces and multiple magnetocaloric materials and a magnetic field with several poles;

Fig. 17 shows a fifth alternative embodiment which employs a multipole magnetic field source, multiple magnetocaloric materials and multiple fluid channels in a cylindrical structure;

Fig. 18 shows a schematic of an electric circuit for regeneration magnetic energy in a magnetic field source;

Fig. 19 shows a schematic operation diagram of a heat engine based on the magnetocaloric effect and a Carnot thermodynamic cycle;

Fig. 20 shows a schematic of an electric circuit for regeneration magnetic energy in a magnetic field source;

Fig. 21 shows a schematic of an electric circuit for regeneration magnetic energy in a magnetic field source;

Fig. 22 shows a diagram of the current flow through the electromagnet with respect to time in the circuit shown in Fig. 18;

Fig. 23 shows a first embodiment of a magnetic field source structure in which a magnetocaloric material is embedded;

Fig. 24 shows a second embodiment of a magnetic field source structure in which a magnetocaloric material is embedded;

Fig. 25 shows a third embodiment of a magnetic field source structure in which a magnetocaloric material is embedded;

Fig. 26 shows a fourth embodiment of a magnetic field source structure in which a magnetocaloric material is embedded;

Fig. 27 shows a fifth embodiment of a magnetic field source structure in which a magnetocaloric material is embedded; and

Fig. 28 shows a sixth embodiment of a magnetic field source structure in which a magnetocaloric material is embedded.

## Detailed description

In the following description of various embodiments, reference will be made to the drawings, in which like reference numerals denote the same or corresponding elements. The drawings are not necessarily to scale. Instead, certain features may be shown exaggerated in scale or in a somewhat simplified or schematic manner, wherein certain conventional elements may have been left out in the interest of exemplifying the principles of the invention rather than cluttering the drawings with details that do not contribute to the understanding of these principles.

Furthermore, those with skill in the art will understand that the invention may be practiced without many of the details included in this detailed description. Conversely, some well-known structures or functions may not be shown or described in detail, in order to avoid unnecessarily obscuring the relevant description of the various implementations. The terminology used in the description presented below is intended to be interpreted in its broadest reasonable manner, even though it is being used in conjunction with a detailed description of certain specific implementations of the invention.

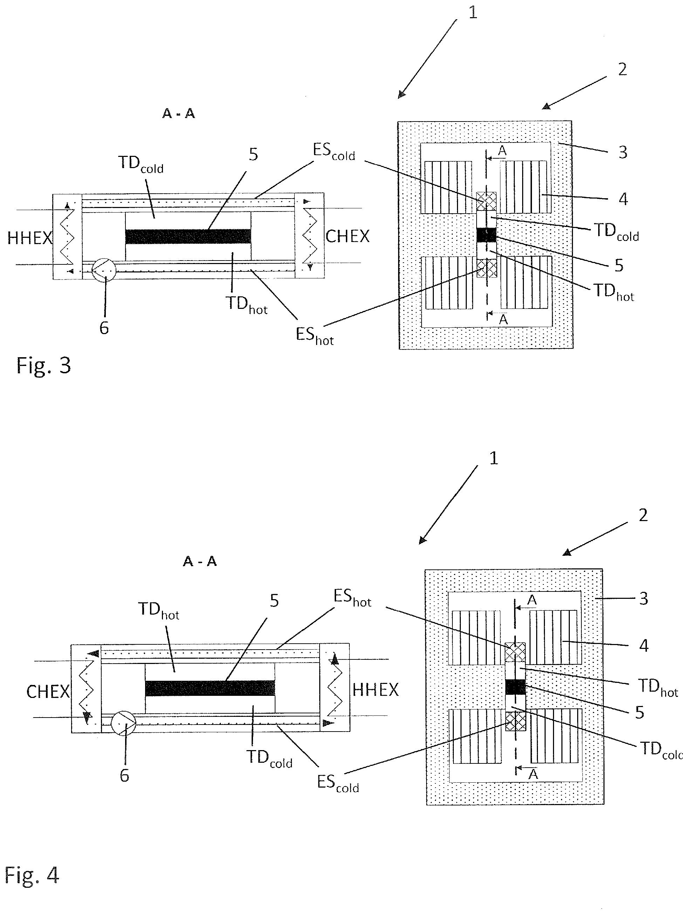

In a first embodiment, as shown in Fig. 3, the micro-magnetocaloric device 1 may operate as a refrigerator or as a heat pump, wherein regeneration of the magnetic energy may be provided and heat may be regenerated according to the thermal switch principle in a combination with the fluid flow in the hydraulic circuit. The device comprises a magnetic field source 2 with an iron or soft ferromagnetic material core 3 and at least one coil winding or other means for electric current flow 4. At least one electric circuit (not shown in Fig. 3) may be provided for the control, regulation of operation and regeneration of the magnetic energy. In the gap between the magnetic poles created by the magnetic field source 2, at least one magnetocaloric material 5 (MC material 5) is provided. As shown in detail in the schematic cross-sectional view on the left hand side of Fig. 3, the MC material 5 is positioned between two thermal switch mechanisms denoted by $TD_{cold}$ and $TD_{hot}$ respectively. To each of these thermal switch mechanisms, a respective extended surface is attached, denoted by $ES_{cold}$ and $ES_{hot}$, respectively. Working fluid is pumped by pumping means 6 in a continuous circuit, as indicated by the arrows, past the respective extended surfaces $ES_{cold}$ and $ES_{hot}$ and through a heat source heat exchanger CHEX and a heat sink heat exchanger HHEX.

The basic operation is the following. When the magnetic field source 2 is switched on, the thermal switch $TD_{hot}$ is in operation, thus representing a means for thermal transport from the magnetocaloric material 5 to the extended surface $ES_{hot}$. Through the extended surface $ES_{hot}$, the working fluid flows in a direction from the heat source heat exchanger CHEX to the heat sink heat exchanger HHEX, wherein the propulsion of the working fluid is provided by the pumping means 6 or by any other working fluid propulsion system. In this manner, the working fluid absorbs heat from the extended surface $ES_{hot}$ and rejects it in the HHEX. Before the magnetic field source 2 is switched off, operation of the thermal switch mechanism $TD_{hot}$ is deactivated. Thus, thermal transport between the magnetocaloric material and the extended surface $ES_{hot}$ can be prevented, wherein the deactivated thermal switch may represent an adiabatic barrier. When the magnetic field source 2 is switched off, the thermal switch mechanism $TD_{cold}$ is activated, thus representing a means for thermal transport to the magnetocaloric material 5 via the thermal switch from the extended surface $ES_{cold}$. Through the extended surface $ES_{cold}$, the working fluid flows in a direction from the heat sink heat exchanger HHEX to the heat source heat exchanger CHEX, wherein the propulsion of the working fluid is provided by the pumping means 6 or by any other working fluid propulsion system. In this manner, the working fluid transfers heat from the extended surface $ES_{cold}$ via the thermal switch $TD_{cold}$ to the magnetocaloric material. 5 This cycle is then repeated. The working fluid may flow continuously or discontinuously, depending on desired thermodynamic cycle. Furthermore, the working fluid flow, the operation of thermal switch mechanisms and the operation of the magnetic field source can be tuned in a manner that the micro-magnetocaloric device operates with different thermodynamic cycles.

Fig. 4 shows a second embodiment of a magnetocaloric device 1. The second embodiment comprises a micro-magnetocaloric device 1 which operates as a power generator with regeneration of the magnetic energy and applies the regeneration of heat performed by the thermal switch principle. In this particular case, at least one magnetocaloric material 5 is embodied between two thermal switch mechanisms, denoted by $TD_{cold}$ and $TD_{hot}$ respectively. To each of these thermal switch mechanisms, respective extended surfaces are attached, denoted by $ES_{cold}$ and $ES_{hot}$, respectively. The basic operation is the following. The magnetic field source 2 may comprise at least one iron or soft ferromagnetic material core 3, at least one coil winding 4 or other means for electric current flow, and at least one electric circuit for the control, regulation of operation and regeneration of the magnetic energy. When the magnetic field source 2 is switched on, the thermal switch $TD_{hot}$ is in operation, thus represents means for thermal transport from the extended surface $ES_{hot}$ to the magnetocaloric material 5. Through the extended surface $ES_{hot}$, the working fluid flows in a direction from the heat source heat exchanger HHEX to the heat sink heat exchanger CHEX, wherein the propulsion of the working fluid is provided by the pumping means 6 or by any other working fluid propulsion system. In this manner, the working fluid from HHEX transfers heat to the extended surface $ES_{hot}$ and to the $TD_{hot}$. In the CHEX, the working fluid removes heat from the system. Before the magnetic field source 2 is switched off, the thermal switch mechanism $TD_{hot}$ is deactivated, thus preventing the thermal transport between the magnetocaloric material 5 and the extended surface $ES_{hot}$, wherein the deactivated thermal switch mechanism $TD_{hot}$ may represent an adiabatic barrier. When the magnetic field source is switched off, the thermal switch mechanism $TD_{cold}$ is activated, thus representing means for thermal transport from the magnetocaloric material 5 via the thermal switch $TD_{cold}$ to the extended surface $ES_{cold}$. Through the extended surface $ES_{cold}$, the working fluid flows in a direction from the heat sink heat exchanger CHEX to the heat source heat exchanger HHEX, wherein the propulsion of the working fluid is provided by the pumping means 6 or by any other working fluid propulsion system. In this manner, the magnetocaloric material 5 transfers heat to the working fluid via the $TD_{cold}$ to the extended surface $ES_{cold}$. This cycle is then repeated. The working fluid may flow continuously or discontinuously, depending on desired thermodynamic cycle. Furthermore, the working fluid flow, the operation of thermal switch mechanisms and the operation of the magnetic field source 2 can be tuned in a manner that the micro-magnetocaloric device operates with different thermodynamic cycles.

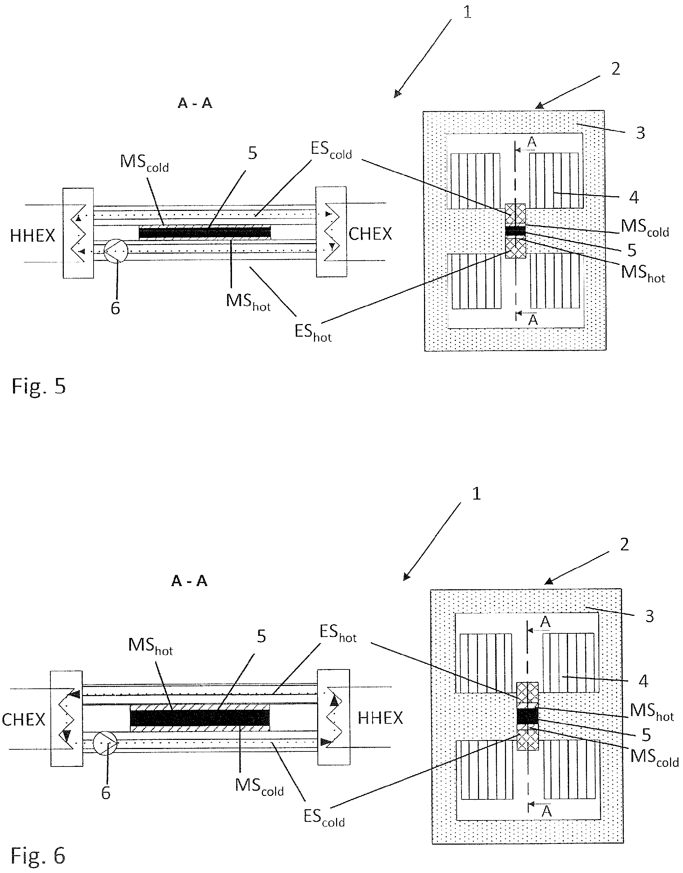

In a third embodiment of this invention, the micro-magnetocaloric device 1 as shown in Figure 5 operates as a refrigerator or as a heat pump with regeneration of the magnetic energy and applies the regeneration of heat using a multifunctional coating on at least one magnetocaloric material 5. In this particular case, the magnetocaloric material 5 is coated with two multifunctional coatings, denoted by multifunctional surface $MS_{cold}$ and multifunctional surface $MS_{hot}$, respectively. Each of these multifunctional coatings may be attached to or may represent a part of the fluid flow channels provided by the extended surfaces $ES_{hot}$ and $ES_{cold}$, respectively.

The basic operation of the micro-magnetocaloric device 1 according to the third embodiment is the following. The magnetic field source 2 may comprise at least one iron or soft ferromagnetic material core 3, at least one coil winding 4 or other means for electric current flow, and at least one electric circuit for the control, regulation of operation and regeneration of the magnetic energy. When the magnetic field source 2 is switched on, the coating comprising the multifunctional surface $MS_{hot}$ is in operation, thus representing a means to influence the thermal or velocity boundary layer, or wetting of the fluid flow. By this, the heat transfer between the magnetocaloric material 5 and the working fluid is enhanced. The coating comprising the multifunctional surface $MS_{hot}$ thus represents a means for influencing the thermal transport from the magnetocaloric material 5 to the working fluid in the extended surface $ES_{hot}$. Through the extended surface $S_{hot}$, the working fluid flows in a direction from the heat source heat exchanger CHEX to the heat sink heat exchanger HHEX, wherein the propulsion of the working fluid is provided by the pumping means 6 or by any other working fluid propulsion system. The working fluid absorbs heat from the extended surface $ES_{hot}$ and the multifunctional surface $MS_{hot}$ and rejects it in the HHEX. Before the magnetic field source 2 is switched off, the multifunctional surface $MS_{hot}$ is deactivated, thus representing a means to prevent the thermal transport between the magnetocaloric material 5 and the working fluid in the extended surface $ES_{hot}$. The deactivated multifunctional surface $MS_{hot}$ may represent an adiabatic barrier by influencing the thermal and velocity boundary layer or wetting of the working fluid. When the magnetic field source 2 is switched off, the multifunctional surface $MS_{cold}$ is activated, thus representing a means for thermal transport from the working fluid in the extended surface $ES_{cold}$ to the magnetocaloric material 5, by influencing the thermal and velocity boundary layer or wetting of the working fluid. Through the extended surface $ES_{cold}$, the working fluid flows in a direction from the heat sink heat exchanger HHEX to the heat source heat exchanger CHEX, wherein the propulsion of the working fluid is provided by the pumping means 6 or by any other working fluid propulsion system. In this manner, the working fluid transfers heat from the extended surface $ES_{cold}$ and the multifunctional surface $MS_{cold}$ to the magnetocaloric material 5. This cycle is then repeated. The working fluid may flow continuously or discontinuously, depending on desired thermodynamic cycle. Furthermore, the working fluid flow, the operation of multifunctional coatings and the operation of the magnetic field source 2 can be tuned in a manner that the micro-magnetocaloric device operates with different thermodynamic cycles.

In the fourth embodiment of this invention, as shown in Fig. 6, the micro-magnetocaloric device 1 operates as a power generator with regeneration of the magnetic energy and applies the regeneration of heat performed by multifunctional coatings on the magnetocaloric material 5. In this particular case, the magnetocaloric material 5 is coated with two multifunctional coatings, denoted by multifunctional surface $MS_{cold}$ and multifunctional surface $MS_{hot}$, respectively.

Each of these coatings are attached to or represent a part of the fluid flow channels provided by extended surfaces, denoted by extended surface $ES_{cold}$ and extended surface $ES_{hot}$, respectively. The basic operation of the micro-magnetocaloric device 1 according to the fourth embodiment is the following. The magnetic field source 2 comprises at least one iron or soft ferromagnetic material core 3, at least one coil winding 4 or other means for electric current flow, and at least one electric circuit for the control, regulation of operation and regeneration of the magnetic energy. When the magnetic field source 2 is switched on, the coating comprising the multifunctional surface $MS_{hot}$ is in operation, thus representing a means to influence the thermal or velocity boundary layer, or wetting of the fluid flow. By this, the heat transfer between the magnetocaloric material 5 and the working fluid is enhanced. The multifunctional surface $MS_{hot}$ thus represents a means for thermal transport from the working fluid to the magnetocaloric material 5. Through the extended surface $ES_{hot}$, the working fluid flows in a direction from the heat source heat exchanger HHEX to the heat sink heat exchanger CHEX, wherein the propulsion of the working fluid is provided by the pumping means 6 or by any other working fluid propulsion system. In this manner, the working fluid transfers heat to the extended surface $ES_{hot}$ and the multifunctional surface $MS_{hot}$. In the heat sink heat exchanger CHEX, the working fluid rejects heat out of the system. Before the magnetic field source 2 is switched off, the multifunctional surface $MS_{hot}$ is deactivated, thus representing a means to prevent the thermal transport between the magnetocaloric material and the working fluid in the extended surface $ES_{hot}$ by influencing the thermal and velocity boundary layer or wetting of the working fluid. Therein, the deactivated multifunctional surface $MS_{hot}$ may represent an adiabatic barrier. When the magnetic field source 2 is switched off, the multifunctional surface $MS_{cold}$ is activated, thus representing a means for thermal transport from the magnetocaloric material 5 via the extended surface $ES_{cold}$ and the multifunctional surface $MS_{cold}$ to the working fluid, by influencing the thermal and velocity boundary layer or wetting of the working fluid. Through the extended surface $ES_{cold}$, the working fluid flows in a direction from the heat sink heat exchanger CHEX to the heat source heat exchanger HHEX, wherein the propulsion of the working fluid is provided by the pumping means 6 or by any other working fluid propulsion system. In this manner, the magnetocaloric material 5 transfers heat to the working fluid via the extended surface $ES_{cold}$ and the multifunctional surface $MS_{cold}$. This cycle is then repeated. The working fluid may flow continuously or discontinuously, depending on desired thermodynamic cycle. Furthermore, the working fluid flow, the operation of multifunctional coatings and the operation of the magnetic field source 2 can be tuned in a manner that the micro-magnetocaloric device operates with different thermodynamic cycles.

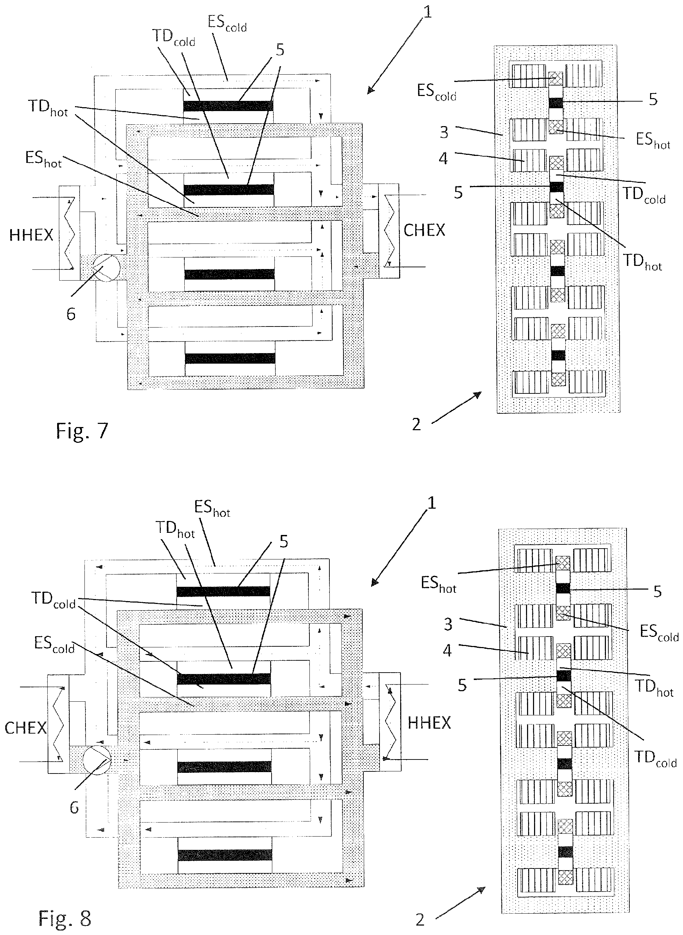

Fig. 7 shows a fifth embodiment, wherein several magnetocaloric materials 5 and an especially designed electric resistive multipole magnetic field source 2 with the regeneration of magnetic energy form a magnetocaloric refrigerator or a heat pump. The principle of the operation of the fifth embodiment is similar as described above for the first embodiment.

Fig. 8 shows a sixth embodiment, wherein several magnetocaloric materials 5 and an especially designed electric resistive multipole magnetic field source 2 with the regeneration of magnetic energy form a magnetocaloric power generator. The principle of the operation of the sixth embodiment is similar as described above for the second embodiment.

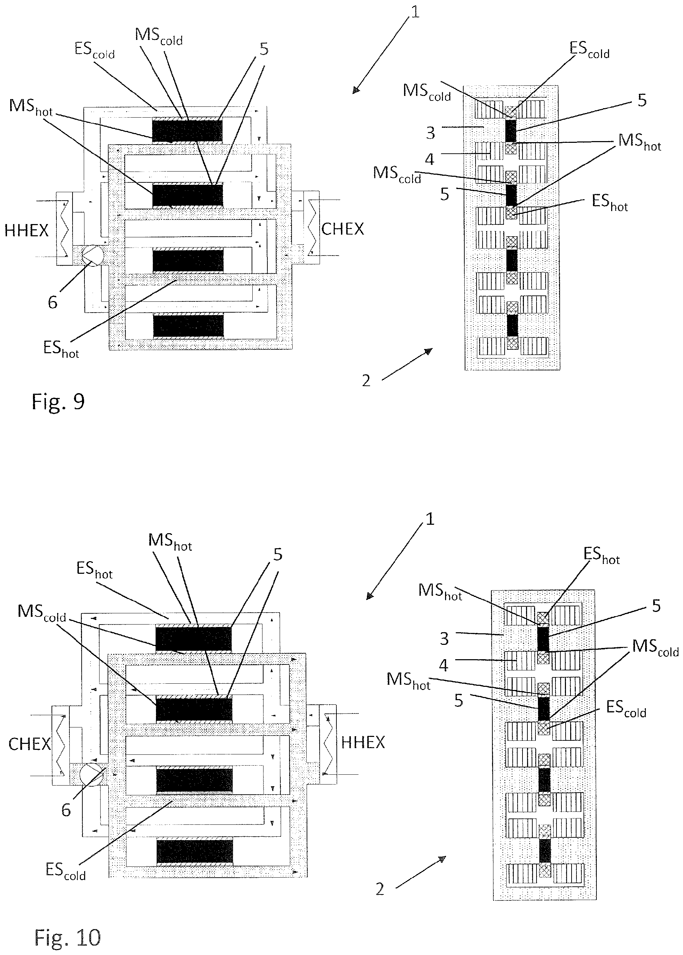

Fig. 9 shows a seventh embodiment, wherein the micro-magnetocaloric device 1 operates as a refrigerator or as a heat pump with regeneration of the magnetic energy and applies the regeneration of heat performed by the multifunctional coating on the magnetocaloric material 5.

This kind of solution comprises several magnetocaloric materials 5 and an especially designed electric resistive multipole magnetic field source 2. In this particular case, the magnetocaloric material 5 is coated with two multifunctional coatings, denoted by multifunctional surface $MS_{cold}$ and multifunctional surface $MS_{hot}$ respectively. The principle of the operation of the seventh embodiment is similar as described above for the third embodiment.

Fig. 10 shows an eighth embodiment, wherein the micro-magnetocaloric device 1 operates as a power generator with regeneration of the magnetic energy and with the regeneration of heat performed by the multifunctional coating on the magnetocaloric material 5. This kind of solution comprises several magnetocaloric materials 5 and an especially designed electric resistive multipole magnetic field source 2. In this particular case, the magnetocaloric material 5 is coated with two multifunctional coatings, denoted by multifunctional surface $MS_{cold}$ and multifunctional surface $MS_{hot}$ respectively. The principle of the operation of the eighth embodiment is similar as described above for the fourth embodiment.

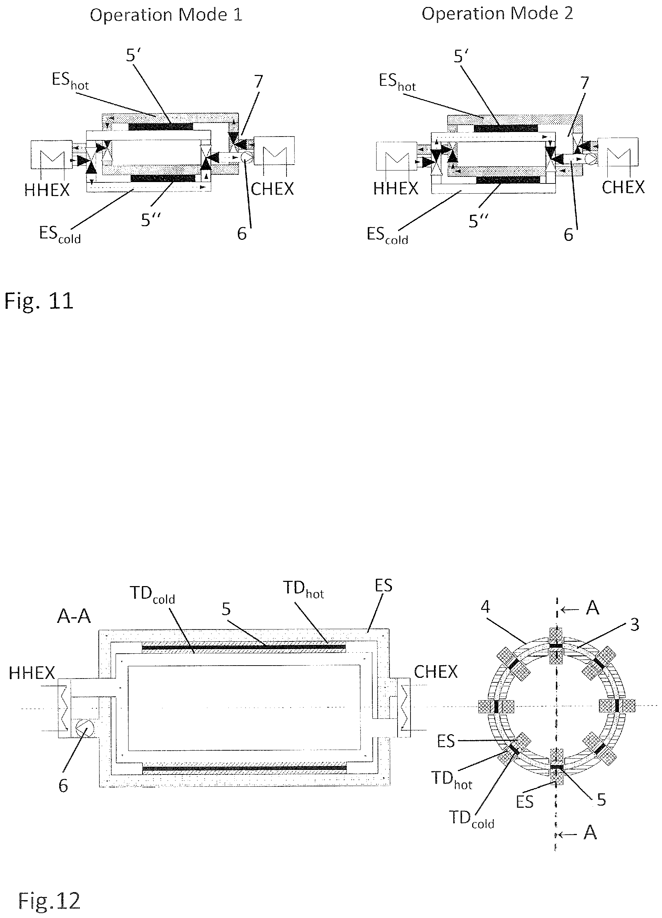

In the ninth embodiment as shown in Fig. 11, an alternative mechanism for the heat transfer between the magnetocaloric material 5 and the working fluid is given. This mechanism may be applied to any other embodiment of the magnetocaloric device 1. This particular mechanism may also be combined with the thermal switch mechanisms or with the multifunctional coatings. The principle of the operation is the following. For each magnetocaloric material 5, the extended surface with the fluid channel(s) is attached above and below the magnetocaloric material. In the embodiment shown in Figure 11, a pair of magnetocaloric materials 5 is provided and two different operation modes of the device are shown on the left and right sides of Fig. 11, respectively. In operation mode 1 as shown on the left side in the Figure 11, the upper magnetocaloric material 5' is magnetized, and the lower magnetocaloric material 5" is demagnetized. Since the magnetized MC material 5' is warm, the working fluid flows through the extended surface $ES_{hot}$ from the CHEX to the HHEX. The extended surface $ES_{hot}$ is in this case positioned above the magnetized magnetocaloric material 5'. Below the magnetized magnetocaloric material 5' is the extended surface $ES_{cold}$. In this case, the working fluid in the channels of the extended surface $ES_{cold}$ is at rest. Because of the difference in the heat transfer coefficient between moving fluid and static fluid, most of the heat is transferred from the magnetized MC material 5' to the working fluid which flows in the extended surface $ES_{hot}$. At the same time, the lower magnetocaloric material 5" is demagnetized. Therefore, the fluid flows through the lower extended surface $ES_{cold}$ which is in contact with the demagnetized MC material 5", while the fluid in the lower extended surface $ES_{hot}$ stays at rest. In operation mode 2 as shown on the right side in Fig. 11, the upper magnetocaloric material 5' is demagnetized, and the lower magnetocaloric material 5" is magnetized. Since the demagnetized MC material 5' is cold, the working fluid flows through the extended surface $ES_{cold}$ below the demagnetized magnetocaloric material 5' from the HHEX to the CHEX. Above the demagnetized magnetocaloric material 5' is the extended surface $ES_{hot}$. In this case, the working fluid in the channels of the extended surface $ES_{hot}$ is at rest. Because of the difference in the heat transfer coefficient between moving fluid and static fluid, most of the heat is transferred from the working fluid (which flows in the extended surface $ES_{cold}$) to the demagnetized material 5'. At the same time, the lower magnetocaloric material 5" is magnetized. Therefore, the fluid flows through the upper extended surface $ES_{hot}$ while the fluid in the upper extended surface $ES_{cold}$ stays at rest. The working fluid flow as shown for both operating modes in Fig. 11 may be continuous while the device is switched between the two operation modes, wherein the working fluid flows in at least two separate channels as described above.

A tenth embodiment, as shown in Fig. 12, relates to a multipole magnetic field source 2 with several magnetocaloric materials 5 and multiple fluid channels which can be implemented in a cylindrical structure. This embodiment may comprise thermal switches, or it may comprise multifunctional material coated on the magnetocaloric material 5 as described above. The magnetocaloric device according to the tenth embodiment may be operated as a refrigerator, heat pump or power generator.

The various embodiments illustrated in Fig. 3 to 12 have the feature in common that the magnetocaloric material is positioned inside the gap between the magnet's poles, and the thermal switches or multifunctional coatings are positioned outside this gap, i.e. on the "top and bottom" surfaces of the magnetocaloric material, when the poles of the magnet are adjacent the side surfaces of the magnetocaloric material. This holds also for solutions, when a special method for the heat transfer is applied as presented in Fig. 11.

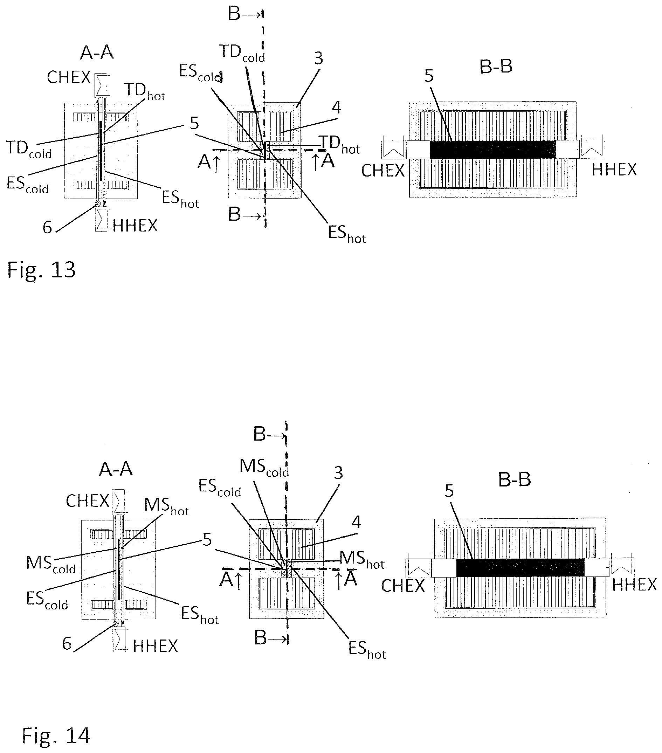

Further alternative embodiments are illustrated in Fig. 13-17.

According to the first alternative embodiment as shown in Fig. 13, the layered structure comprising the magnetocaloric material 5 and the thermal switches $TD_{hot}$ and $TD_{cold}$, similar to the structure as described above in conjunction with Fig. 4, is positioned such that the respective thermal switches $TD_{hot}$ and $TD_{cold}$ are located adjacent the poles of the magnet's iron core 3, with the magnetocaloric material 5 sandwiched between the thermal switches $TD_{hot}$ and $TD_{cold}$. Thus, it can be ensured that the surfaces of the magnetocaloric material 5 which are in direct contact with the thermal switches $TD_{hot}$ and $TD_{cold}$ are located in a region of maximum magnetic field strength.

Fig. 14 shows a second alternative embodiment, which differs from the first alternative embodiment of Fig. 13 in that multifunctional surfaces are provided instead of thermal switches.

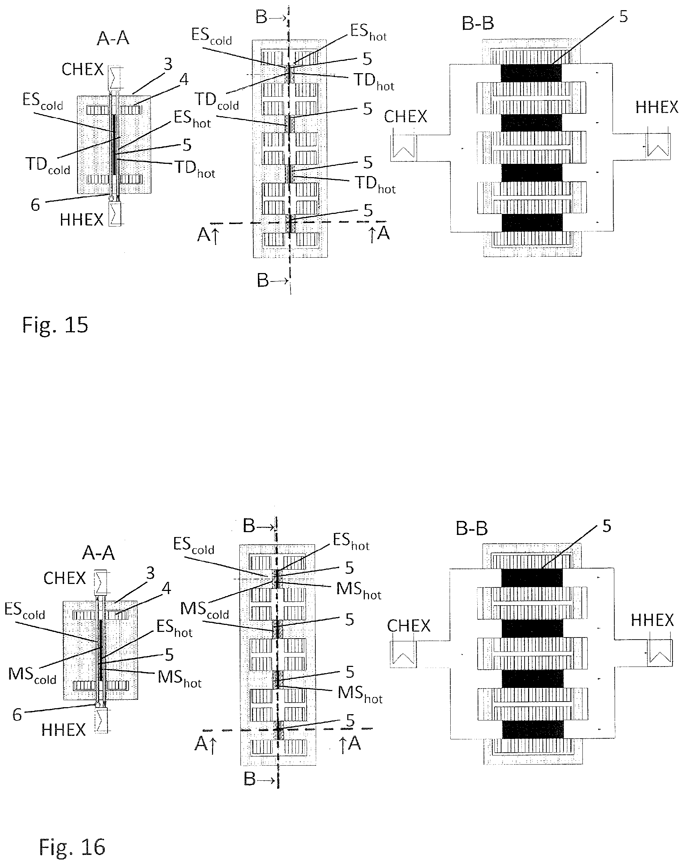

In the third alternative embodiment, as shown in Fig. 15, thermal switches and multiple magnetocaloric materials 5 are provided in conjunction with a magnetic field source 2 with several poles and in the fourth alternative embodiment, as shown in Fig. 16, multifunctional surfaces and multiple magnetocaloric materials 5 are provided in conjunction with a magnetic field source 2 with several poles.

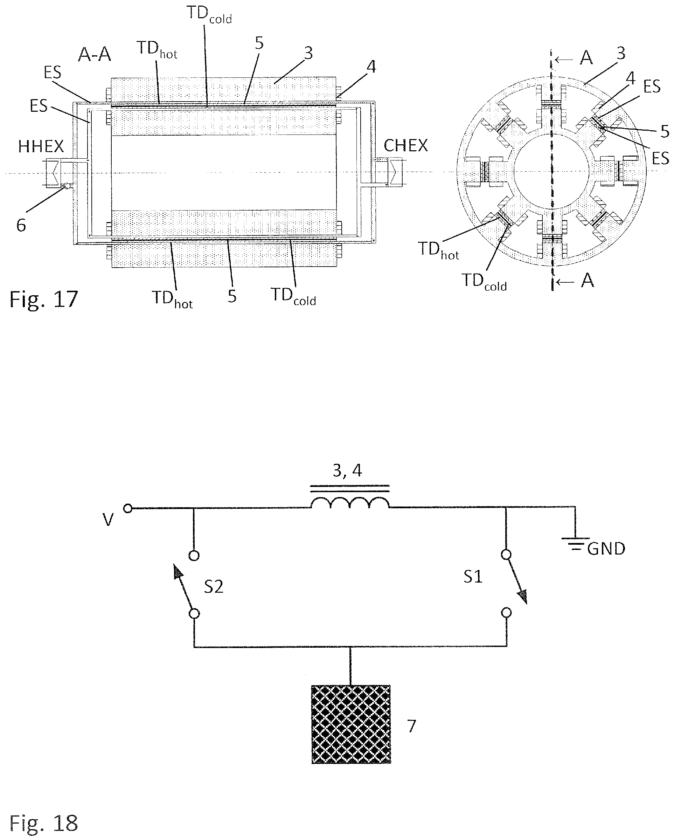

Fig. 17 shows a fifth alternative embodiment, wherein a multipole magnetic field source 2 is provided in conjunction with several magnetocaloric materials 5 and multiple fluid channels in a cylindrical structure.

In all of the embodiments of the present invention, an electric circuit, as a part of the magnetic field source, may enable the regeneration of the magnetic energy. Embodiments of electric circuits are shown in Figures 18, 20 and 21.

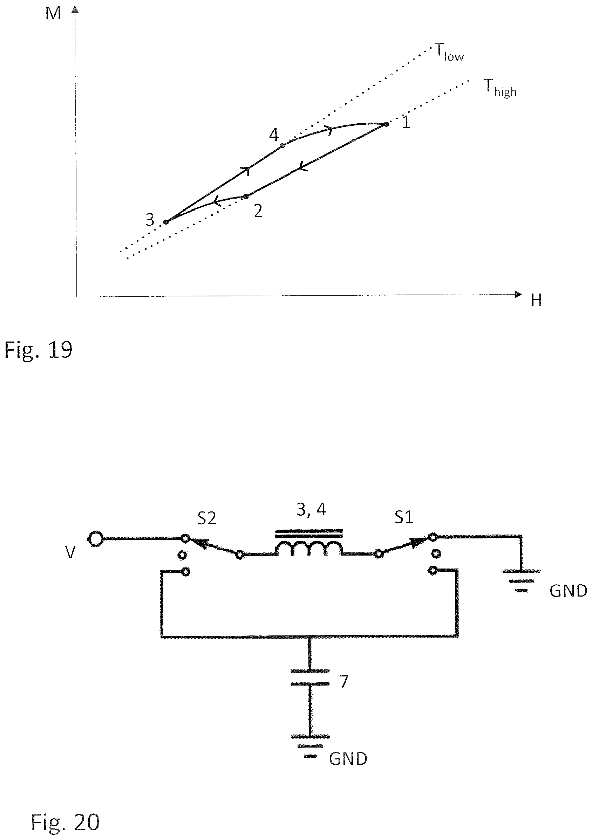

Fig. 18 shows a general schematic diagram of a circuit as part of the magnetic field source 2 for storing and regeneration of the magnetic field energy. Figure 19 shows the schematics of the operation of a heat engine, based on the magnetocaloric effect and a Carnot thermodynamic cycle.

The energy of the magnetic field of the electromagnet can be equivalently expressed as

$$E_{magn} = \frac{1}{2}LI^2,$$

where L is the inductance of the electromagnet and I is the current that flows through the coil of the electromagnet. As shown in Figure 18, switcher S1 is used to redirect the current that flows through the electromagnet 3, 4 into an energy collector device 7, which could be a battery or a capacitor or other similar element. When the current stops flowing, the magnetic field in the electromagnet vanishes and the energy collector device is charged.

To turn on the magnetic field in the electromagnet, the switch S2 is used to release the energy stored in the energy collector to start the current flow through the electromagnet.

Due to resistive losses and losses of the energy collector device, a voltage source V is required, which maintains the current, once the current flow is established.

The circuit primarily acts as an efficient switching and energy storage device. The operation, combined with magnetocaloric material, is the following. In the case of refrigeration or heat pumping, the following steps are performed. When the magnetic field turns on (S2 turns on), the magnetocaloric material heats up, then heat transfer between the magnetocaloric material and working fluid is established (via advanced heat transfer solutions presented in this invention) so the magnetocaloric material dissipates heat into the working fluid. When the magnetic field is turned off (S1 turns on), the magnetocaloric material cools and when brought in contact with the working fluid (via advanced heat transfer solutions presented in this invention), it absorbs heat from the working fluid.

When the magnetocaloric device 1 operates as a heat engine (power generator), the procedure is reversed. The operation for the Carnot thermodynamic cycle will be described, however one should note that also other thermodynamic cycles can be developed. In the first stage (Figs. 18, 19, processes 1 to 3) the switch S1 is turned on and the current from the electromagnet starts charging the energy collector device. During this stage the magnetocaloric material would start cooling due to the magnetocaloric effect, however when brought in contact with the hot working fluid (hot thermal switches turned ON or multifunctional coating ON), the magnetocaloric material absorbs heat from the working fluid. Therefore, according to the example, the material is demagnetizing isothermally (Fig. 19, process 1-2). Then (Fig. 19, 2-3) the hot thermal switches ($TD_{hot}$)are turned off (or the multifuntional coating is set OFF) and the magnetocaloric material 5 is now thermally isolated, however still demagnetizing. Due to the magnetocaloric effect, the magnetocaloric material cools down. In the second stage (Fig. 19, processes 3 to 1), the switch S2 is turned on and the energy from the energy collector device starts the current flow in the electromagnet. During this stage, the magnetocaloric material 5 would heat up due to the magnetocaloric effect, however when brought in contact with the working fluid (cold thermal switches $TD_{cold}$ are turned ON or the mutifunctional coating on the cold side is set ON), the magnetocaloric material 5 transfers heat into the working fluid. As the example, the magnetocaloric material 5 is magnetizing isothermally in this step (Fig. 19, process 3-4). Then (Fig. 19, process 4-1) the cold thermal switches $TD_{cold}$ are turned OFF (or the multifunctional coating is set OFF), therefore the magnetocaloric material 5 heats up. From the thermodynamics of the magnetocaloric effect, it follows that the energy stored in the first stage of the processes (1 to 3) is larger then the energy used in the second stage of the processes (3 to 4), that is, there remains a part of the energy that can be used for other mechanical or electrical work.

Fig. 20 shows an implementation of the concept illustrated in Fig. 18. The energy collector device 7 in this case is a capacitor (condenser). The switching operation is explained below:

1. The current flows trough S1 and S2, from voltage source V to ground GND.

2. S1 switches from GND to capacitor 7, now the current flows into the capacitor 7.

3. At the moment when the current stops flowing, the capacitor 7 is charged and S1 and S2 are switched to neutral position.

4. Switching S1 to GND and S2 to the electromagnet 3, 4 starts the current flow in the electromagnet 3, 4 (by discharging the capacitor 7).

5. When the capacitor 7 is discharged (or when the desired current is reached) S2 connects the electromagnet 3, 4 to the voltage source to maintain the current in the electromagnet 3, 4.

6. The cycle is repeated.

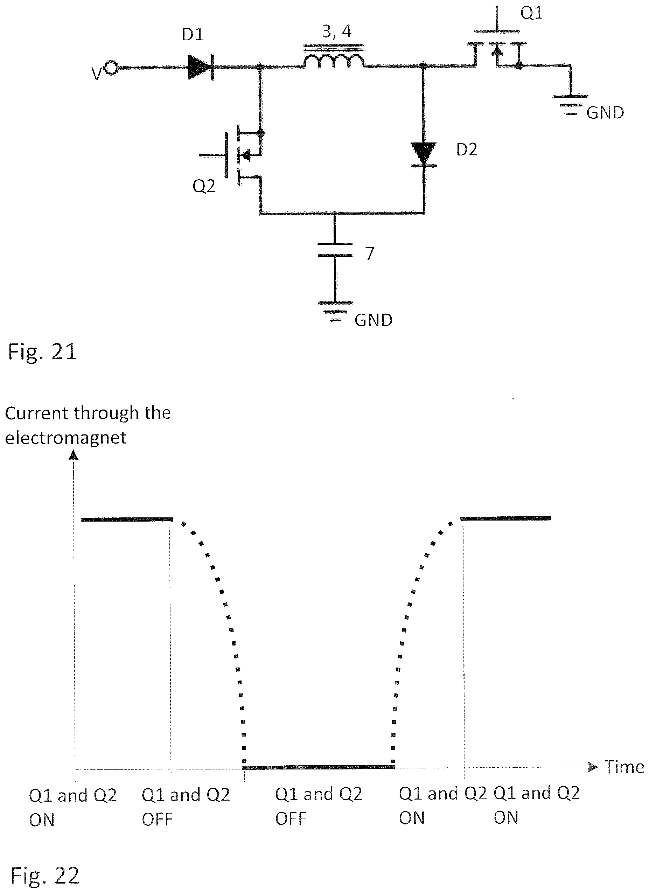

Fig. 21 shows a further implementation of the circuit described in Fig. 18 and 20. It uses mosfets as switches (gate drivers are not shown). The switching operation is explained below:

1. The current flows in the electromagnet through diode D1 and mosfet Q1, from voltage source V to ground GND.

2. Mosfets Q1 and Q2 are simultaneously turned off, which forces the current in the electromagnet to charge the capacitor. When the current stops flowing, the capacitor is charged and the magnetic field vanishes.

3. Now mosfets Q1 and Q2 are simultaneously turned on. The currents start flowing from the capacitor to GND. Diode D2 prevents the capacitor to discharge directly to GND and diode D1 prevents the current to flow from the capacitor into the voltage source.

4. When the capacitor is dicharged the voltage source V maintains the current in the electromagnet.

5. The cycle is repeated.

When the steps 1., 2., 3., 4. are carried out, the current in the electromagnet changes in time as depicted in Fig. 22, which shows the flow of current through the electromagnet with respect to time, when the steps 1.-4. are implemented in circuit shown on Fig. 21.

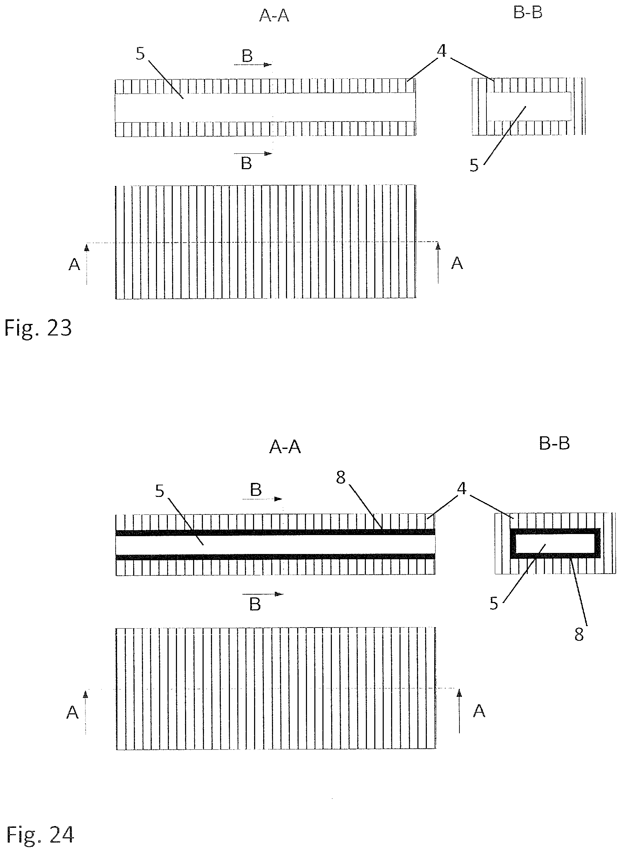

For all embodiments of the invention, the magnetic field source 2 with the regeneration of magnetic energy, as described above, may also represent a structure in which the magnetocaloric material 5 is embedded. Some embodiments thereof are shown in Fig. 23 to 28. Note that in all the cases of Figs. 23 to 28, the heat transfer principles described in conjunction with the embodiment illustrated in Figs. 3 to 16 may be applied.

Fig. 23 shows a first embodiment of a magnetic field source 2 as a structure in which the magnetocaloric material 5 is embedded. Therein, the electric coil 4 of the magnetic field source 2 may surround the magnetocaloric material 5. In this particular case, the electric coil is in direct contact with a working fluid, or a multifunctional coating, or a thermal switch.

Fig. 24 shows a second embodiment of a magnetic field source 2 wherein the magnetocaloric material 5 is embedded. Therein, a layer of soft ferromagnetic material 8 may be provided between the magnetocaloric material 5 and the surrounding electric coil 4. Also in this particular case, the electric coil is in direct contact with a working fluid, or a multifunctional coating, or a thermal switch.

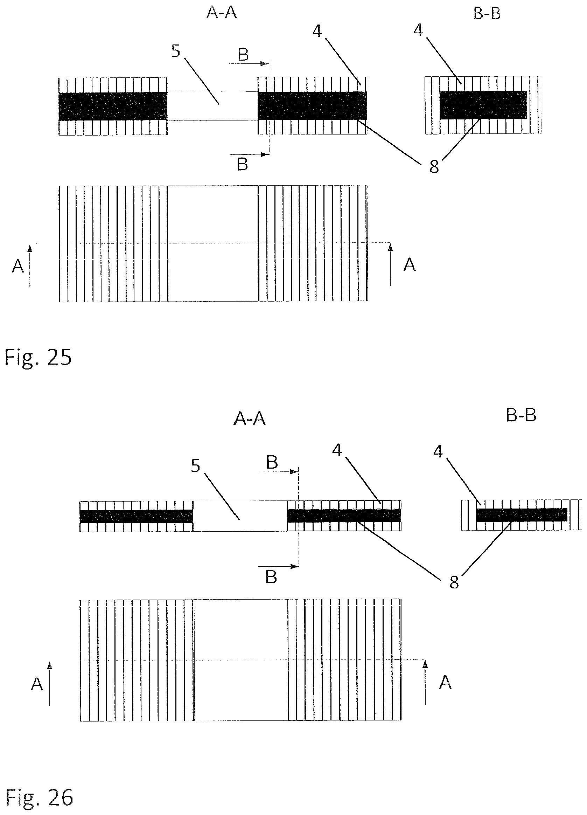

Fig. 25 shows a third embodiment of a magnetic field source 2 wherein the magnetocaloric material 5 is embedded. Therein, the magnetocaloric material 5 is provided inside the iron core 3, wherein respective regions of a soft ferromagnetic material 8, which are surrounded by respective section of electric coil 4, are located at opposite sides of the magnetocaloric material 5. In contrary to examples in Figs.23 and 24, in this particular case, the magnetocaloric material is coated or embodied as for other examples within this invention.

Fig. 26 shows a fourth embodiment of a magnetic field source 2 wherein the magnetocaloric material 5 is embedded. In contrast to the third embodiment of Fig. 25, the magnetocaloric material 5 abuts not only the adjacent regions of soft ferromagnetic material 8, but is also in direct contact with the electric coil 4 which surrounds the soft ferromagnetic material 8. In contrary to examples in Figs.23 and 24, also in this particular case, the magnetocaloric material is coated or embodied as for other examples within this invention.

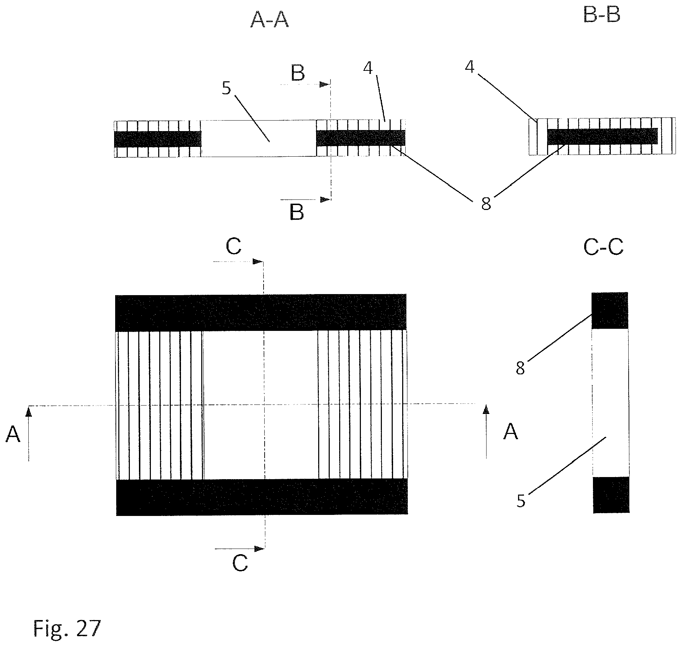

Fig. 27 shows a fifth embodiment of a magnetic field source 2 wherein the magnetocaloric material 5 is embedded. Therein, the magnetocaloric material is sandwiched between two layers of soft ferromagnetic material 8. In contrary to examples in Figs. 23 and 24, also in this particular case, the magnetocaloric material is coated or embodied as for other examples within this invention.

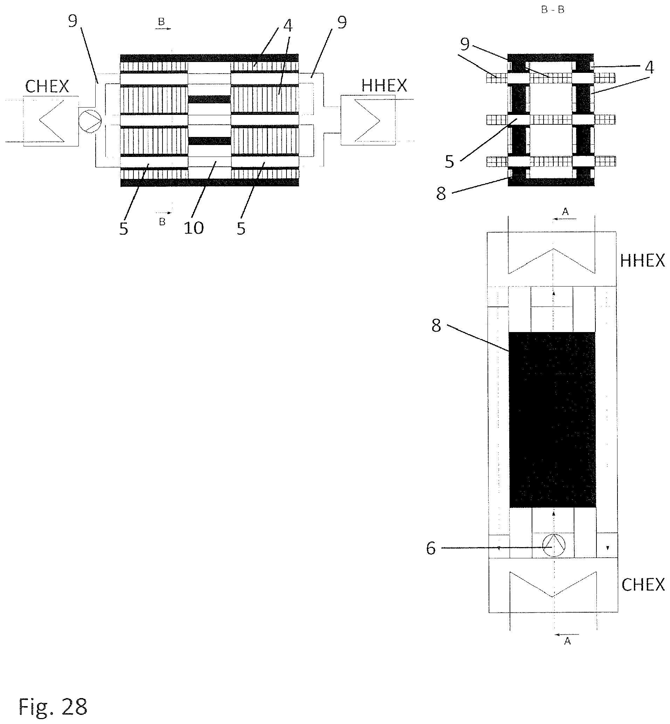

Fig. 28 shows a sixth embodiment of a magnetic field source 2 wherein the magnetocaloric material 5 is embedded. Therein, a multilayer structure is formed, wherein layers of magnetocaloric material 5 are provided with fluid channels 9 within the magnetic field source 2.

Thermally conductive material 10 may be provided which may connect two separate layers of magnetocaloric material 5. The fluid channels 9 may be formed, as described above, in and/or adjacent to thermal switches or multifunctional coatings provided on respective surfaces of the magnetocaloric material.

The effects of applying the alternative embodiments shown in Fig. 23-28, compared to other embodiments described herein, is in the further miniaturization of the magnetic field source, and as the consequence, of the device. Furthermore, such embodiments can bring advantages in compensating for poor mechanical properties of some magnetocaloric materials. Moreover, these embodiments can also provide enhancement of the effective thermal conductivity. Moreover, but this holds also to other embodiments describe above, Figures 23-28 show modifications in which the magnetic field source magnetizes only the magnetocaloric material 5 and not the empty space between the magnetocaloric material and fluid voids. This last is actually a drawback of the well known active magnetic regenerator.

As an alternative to any of given solutions in this invention, the magnetic field source, besides of an electric coil, may comprise an additional permanent magnet material.

**Claims**

1. Magnetocaloric device (1), comprising:

- two heat transfer structures ($TD_{hot}$, $TD_{cold}$, $MS_{hot}$, $MS_{cold}$);

- at least one magnetocaloric material (5) embedded between the two heat transfer structures ($TD_{hot}$, $TD_{cold}$; $MS_{hot}$, $MS_{cold}$);
- at least one electric source (2) for generating a magnetic field which enables regeneration of the magnetic energy,

wherein the electric source (2) comprises an electromagnet (3, 4) and an energy collector device (7), wherein the electric source (2) is adapted to charge the energy collector device (7) when the magnetic field of the electromagnet (3, 4) is turned off, and use the charged energy collector device (7) for generation of a magnetic field in the electromagnet (3, 4) when the magnetic field is turned on, and wherein the electric source (2) further comprises a first switching device (S1) for connecting the electromagnet (3, 4) to the energy collector device for charging the energy colletor device (7) and a second switching device (S2) for connecting the energy collector device (7) to the electromagnet (3, 4) for turning on the magnetic field in the electromagnet by releasing the energy stored in the energy collector device (7) to start the current flow through the electromagnet (3, 4); and

- at least one hydraulic circuit which comprises at least one propulsion means (6) for the working fluid,

wherein the heat transfer structures ($TD_{hot}$, $TD_{cold}$; $MS_{hot}$, $MS_{cold}$) are adapted to control the transfer or transport of heat between the magnetocaloric material (5) and the working fluid.

2. Magnetocaloric device (1) according to claim 1, wherein the energy collector device (7) comprises a battery or a capacitor.

3. Magnetocaloric device (1) according to any of claims 1 or 2, further comprising at least one permanent magnet material, wherein the magnetic field is generated by the at least one electric source (2) and the at least one permanent magnet material.

4. Magnetocaloric device (1) according to any one of the previous claims, wherein the working fluid flows in a constant direction.

5. Magnetocaloric device (1) according to any one of the previous claims, wherein the heat transfer structures comprise at least one thermal switch ($TD_{hot}$, $TD_{cold}$) which is adapted to control heat transfer or heat transport from the magnetocaloric material (5) to the hydraulic circuit and/or from the hydraulic circuit to the magnetocaloric material (5).

6. Magnetocaloric device (1) according to any one of the previous claims, wherein the heat transfer structures comprise at least one multifunctional coating ($MS_{hot}$, $MS_{cold}$) which is adapted to affect the wetting effect of the working fluid, or/and to affect the thermal or velocity boundary layer of the working fluid, or/and to affect the chemical protection of the magnetocaloric material (5), and/or to affect the mechanical properties of the magnetocaloric material (5), and/or to affect the effective thermal properties of the magnetocaloric material (5) and/or the multifunctional coating ($MS_{hot}$, $MS_{cold}$).

7. Magnetocaloric device (1) according to any one of the previous claims, where the hydraulic circuit with the working fluid includes at least one heat exchanger (CHEX, HHEX), such as a heat source or/and a heat sink heat exchanger.

8. Magnetocaloric device (1) according to any one of the previous claims, comprising at least one magnetic field source and a plurality of magnetocaloric materials (5), wherein each magnetocaloric material (5) is embedded between the two heat transfer structures ($TD_{hot}$, $TD_{cold}$; $MS_{hot}$, $MS_{cold}$), and wherein a common hydraulic circuit is provided such that the heat transfer structures ($TD_{hot}$, $TD_{cold}$; $MS_{hot}$, $MS_{cold}$) are adapted to control the transfer or transport of heat between each magnetocaloric material (5) and the working fluid.

9. Magnetocaloric device (1) according to any one of the previous claims, wherein several subdevices form a cascade system.

10. Magnetocaloric device (1) according to claim 5, wherein the thermal switch ($TD_{hot}$, $TD_{cold}$) comprises at least one thermal switch material which exhibits anisotropy of the thermal conductivity or comprises at least one thermal switch composite material which exhibits anisotropy of the effective thermal conductivity.

11. Magnetocaloric device (1) according to claim 5, wherein the thermal switch ($TD_{hot}$, $TD_{cold}$) is based on mechanical contact by elastomer materials, or liquid crystals, or based on ferrofluids, or magnetorheologic principles, or liquid metals, or electrorheologic principles, or electrowetting principles, or electrophoresis principles, or magnetohydrodynamics, or electrohydrodynamics.

12. Magnetocaloric device (1) according to claim 5, wherein the thermal switch ($TD_{hot}$, $TD_{cold}$) is based on thermoelectric (Peltier or Seebeck), or thermionic, or spincaloritronic (spin Peltier or spin Seebeck) transport effects.

**Patentansprüche**

1. Magnetokolarische Vorrichtung (1), umfassend:

- zwei Wärmeübertragungsstrukturen (TDwarm, TDkalt; $MS_{warm}$, MSkalt)
- mindestens ein magnetokolarisches Material (5), das zwischen den zwei Wärmeübertragungsstrukturen ($TD_{warm}$, TDkalt; $MS_{warm}$, $MS_{kalt}$) eingebettet ist;
- mindestens eine elektrische Quelle (2) zur Erzeugung eines Magnetfelds, das die Regenerierung der magnetischen Energie ermöglicht,

wobei die elektrische Quelle (2) einen Elektromagneten (3, 4) und eine Energiesammelvorrichtung (7) umfasst, wobei die elektrische Quelle (2) dafür eingerichtet ist, die Energiesammelvorrichtung (7) aufzuladen, wenn das Magnetfeld des Elektromagneten (3, 4) abgeschaltet ist, und die aufgeladene Energiesammelvorrichtung (7) zur Erzeugung eines Magnetfelds im Elektromagneten (3, 4) anzuwenden, wenn das Magnetfeld eingeschaltet ist, und
wobei die elektrische Quelle (2) weiter eine erste Schaltvorrichtung (S1) zum Verbinden des Elektromagneten (3, 4) mit der Energiesammelvorrichtung zum Aufladen der Energiesammelvorrichtung (7) und eine zweite Schaltvorrichtung (S2) zum Verbinden der Energiesammelvorrichtung (7) mit dem Elektromagneten (3, 4) zum Einschalten des Magnetfelds im Elektromagneten durch Freigabe der in der Energiesammelvorrichtung (7) gespeicherten Energie zum Einleiten des Stromflusses durch den Elektromagneten (3, 4) umfasst; und

- mindestens einen hydraulischen Kreislauf, der mindestens ein Antriebsmittel (6) für das Arbeitsfluid umfasst,

wobei die Wärmeübertragungsstrukturen (TD$_{warm}$, TD$_{kalt}$; MS$_{warm}$, MS$_{kalt}$) dafür eingerichtet sind, Übertragung oder Transport von Wärme zwischen dem magnetokolarischen Material (5) und dem Arbeitsfluid zu steuern.

2. Magnetokolarische Vorrichtung (1) nach Anspruch 1, wobei die Energiesammelvorrichtung (7) eine Batterie oder einen Kondensator umfasst.

3. Magnetokolarische Vorrichtung (1) nach einem der Ansprüche 1 oder 2, weiter umfassend mindestens ein Permanentmagnetmaterial, wobei das Magnetfeld durch die mindestens eine elektrische Quelle (2) und das mindestens eine Permanentmagnetmaterial erzeugt wird.

4. Magnetokolarische Vorrichtung (1) nach einem der vorgehenden Ansprüche, wobei das Arbeitsfluid in einer konstanten Richtung strömt.

5. Magnetokolarische Vorrichtung (1) nach einem der vorgehenden Ansprüche, wobei die Wärmeübertragungsstrukturen mindestens einen thermischen Schalter (TD$_{warm}$, TD$_{kalt}$) umfassen, der dafür eingerichtet ist, die Wärmeübertragung oder den Wärmetransport vom magnetokolarischen Material (5) zum hydraulischen Kreislauf und/oder vom hydraulischen Kreislauf zum magnetokolarischen Material (5) zu steuern.

6. Magnetokolarische Vorrichtung (1) nach einem der vorgehenden Ansprüche, wobei die Wärmeübertragungsstrukturen mindestens eine multifunktionale Beschichtung (MS$_{warm}$, MS$_{kalt}$) umfassen, die dafür eingerichtet ist, die Benetzungswirkung des Arbeitsfluids und/oder die thermische oder Geschwindigkeitsgrenzschicht des Arbeitsfluids und/oder den chemischen Schutz des magnetokolarischen Materials (5) und/oder die mechanischen Eigenschaften des magnetokolarischen Materials (5) und/oder die effektiven thermischen Eigenschaften des magnetokolarischen Materials (5) und/oder die multifunktionale Beschichtung (MS$_{warm}$, MS$_{kalt}$) zu beeinflussen.

7. Magnetokolarische Vorrichtung (1) nach einem der vorgehenden Ansprüche, wobei der hydraulische Kreislauf mit dem Arbeitsfluid mindestens einen Wärmetauscher (CHEX, HHEX), wie beispielsweise eine Wärmequelle und/oder einen Wärmesenkewärmetauscher umfasst.

8. Magnetokolarische Vorrichtung (1) nach einem der vorgehenden Ansprüche, umfassend mindestens eine Magnetfeldquelle und eine Mehrheit von magnetokolarischen Materialien (5), wobei jedes magnetokolarische Material (5) zwischen den zwei Wärmeübertragungsstrukturen (TD$_{warm}$, TD$_{kalt}$; MS$_{warm}$, MS$_{kalt}$) eingebettet ist, und wobei ein gemeinsamer hydraulischer Kreislauf bereitgestellt ist, so dass die Wärmeübertragungsstrukturen (TD$_{warm}$, TD$_{kalt}$; MS$_{warm}$, MS$_{kalt}$) zum Steuern der Übertragung oder des Transports von Wärme zwischen jedem magnetokolarischen Material (5) und dem Arbeitsfluid eingerichtet sind.

9. Magnetokolarische Vorrichtung (1) nach einem der vorgehenden Ansprüche, wobei mehrere Untervorrichtungen ein Kaskadensystem bilden.

10. Magnetokolarische Vorrichtung (1) nach Anspruch 5, wobei der thermische Schalter (TD$_{warm}$, TD$_{kalt}$) mindestens ein thermisches Schaltermaterial umfasst, das Anisotropie der thermischen Leitfähigkeit aufweist oder mindestens ein thermisches Schalterverbundmaterial umfasst, das Anisotropie der effektiven thermischen Leitfähigkeit aufweist.

11. Magnetokolarische Vorrichtung (1) nach Anspruch 5, wobei der thermische Schalter (TD$_{warm}$, TD$_{kalt}$) auf mechanischem Kontakt durch Elastomermaterialien oder Flüssigkristallen basiert oder auf Ferrofluiden oder magnetokolarischen Prinzipien oder Flüssigmetallen oder elektrorheologischen Prinzipien oder Elektrobenetzungsprinzipien oder Elektrophoreseprinzipien oder Magnetohydrodynamik oder Elektrohydrodynamik basiert.

12. Magnetokolarische Vorrichtung (1) nach Anspruch 5, wobei der thermische Schalter (TD$_{warm}$, TD$_{kalt}$)

auf thermoelektrischen (Peltier oder Seebeck) oder thermionischen oder spinkaloritronischen (spin Peltier oder spin Seebeck) Transportauswirkungen basiert.

**Revendications**

1. Dispositif magnétocalorique (1), comprenant :

   - deux structures caloporteuses (TDchaud, TDfroid; MSchaud, MSfroid)
   - au moins un matériau magnétocalorique (5) noyé entre les deux structures caloporteuses (TD$_{chaud}$, TD$_{froid}$; MSchaud, MS$_{froid}$);
   - au moins une source électrique (2) pour générer un champ magnétique qui permet la régénération de l'énergie magnétique,
   - dans lequel la source électrique (2) comprend un électro-aimant (3, 4) et un dispositif collecteur d'énergie (7), dans lequel la source électrique (2) est adaptée pour charger le dispositif collecteur d'énergie (7) lorsque le champ magnétique de l'électro-aimant (3, 4) est désactivé, et utiliser le dispositif collecteur d'énergie chargée (7) pour générer un champ magnétique dans l'électro-aimant (3, 4) lorsque le champ magnétique est activé, et
   - dans lequel la source électrique (2) comprend en outre un premier dispositif de commutation (S1) pour connecter l'électro-aimant (3, 4) au dispositif collecteur d'énergie pour charger le dispositif collecteur d'énergie (7) et un deuxième dispositif de commutation (S2) pour connecter le dispositif collecteur d'énergie (7) à l'électro-aimant (3, 4) pour activer le champ magnétique dans l'électro-aimant en libérant l'énergie stockée dans le dispositif collecteur d'énergie (7) pour démarrer l'écoulement de courant à travers l'électroaimant (3, 4) ; et
   - au moins un circuit hydraulique qui comprend au moins un moyen de propulsion (6) pour le fluide de travail,

   dans lequel les structures caloporteuses (TD$_{chaud}$, TD$_{froid}$; MS$_{chaud}$, MS$_{froid}$) sont adaptées pour commander le transfert ou le transport de chaleur entre le matériau magnétocalorique (5) et le fluide de travail.

2. Dispositif magnétocalorique (1) selon la revendication 1, dans lequel le dispositif collecteur d'énergie (7) comprend une batterie ou un condensateur.

3. Dispositif magnétocalorique (1) selon l'une quelconque des revendications 1 ou 2, comprenant en outre au moins un matériau d'aimant permanent, dans lequel le champ magnétique est généré par au moins une source électrique (2) et au moins un matériau d'aimant permanent.

4. Dispositif magnétocalorique (1) selon l'une quelconque des revendications précédentes, dans lequel le fluide de travail circule dans une direction constante.

5. Dispositif magnétocalorique (1) selon l'une quelconque des revendications précédentes, dans lequel lequel les structures caloporteuses comprennent au moins un interrupteur thermique (TD$_{chaud}$, TD$_{froid}$) qui est adapté pour réguler le transfert de chaleur ou le transport de chaleur du matériau magnétocalorique (5) vers le circuit hydraulique et /ou du circuit hydraulique au matériau magnétocalorique (5).

6. Dispositif magnétocalorique (1) selon l'une quelconque des revendications précédentes, dans lequel lequel les structures caloporteuses comprennent au moins un revêtement multifonctionnel (MS$_{chaud}$, MS$_{froid}$) qui est adapté pour affecter l'effet mouillant du fluide de travail, ou / et pour affecter la couche limite thermique ou de vitesse du fluide de travail, ou / et affecter la protection chimique du matériau magnétocalorique (5), et / ou affecter les propriétés mécaniques du matériau magnétocalorique (5), et / ou affecter les propriétés thermiques effectives du matériau magnétocalorique (5) et /ou le revêtement multifonctionnel (MSchaud, MSfroid).

7. Dispositif magnétocalorique (1) selon l'une quelconque des revendications précédentes, dans lequel le circuit hydraulique avec le fluide de travail est relié à au moins un échangeur de chaleur (CHEX, HHEX), tel qu'une source de chaleur ou / et un échangeur de chaleur dissipateur.

8. Dispositif magnétocalorique (1) selon l'une quelconque des revendications précédentes, comprenant au moins une source de champ magnétique et une pluralité de matériaux magnétocaloriques (5), dans lequel chaque matériau magnétocalorique (5) est noyé entre deux structures caloporteuses (TD$_{chaud}$, TD$_{froid}$; MS$_{chaleur}$, MS$_{froid}$), et dans lequel un circuit hydraulique commun est prévu de telle sorte que les structures caloporteuses (TD$_{chaud}$, TD$_{froid}$; MS$_{chaud}$, MS$_{froid}$) sont adaptées pour commander le transfert ou le transport de chaleur entre chaque matériau magnétocalorique (5) et le fluide de travail.

9. Dispositif magnétocalorique (1) selon l'une quelconque des revendications précédentes, dans lequel plusieurs sous-dispositifs forment un système en cascade.

10. Dispositif magnétocalorique (1) selon la revendication 5, dans lequel le commutateur thermique ($TD_{chaud}$, $TD_{froid}$) comprend au moins un matériau de commutateur thermique qui présente une anisotropie de la conductivité thermique ou comprend au moins un matériau composite de commutateur thermique qui présente une anisotropie de la conductivité thermique effective.

11. Dispositif magnétocalorique (1) selon la revendication 5, dans lequel le commutateur thermique ($TD_{chaud}$, $TD_{froid}$) est basé sur un contact mécanique par des matériaux élastomères, ou cristaux liquides, ou à base de ferrofluides, ou principes magnétorhéologiques, ou métaux liquides, ou principes électrorhéologiques, ou principes d'électromouillage, ou principes d'électrophorèse, ou magnétohydrodynamique, ou électrohydrodynamique.

12. Dispositif magnétocalorique (1) selon la revendication 5, dans lequel le commutateur thermique ($TD_{chaud}$, $TD_{froid}$) est basé sur des effets de transport thermoélectrique (Peltier ou Seebeck), ou thermoionique, ou spincaloritronic (spin Peltier ou spin Seebeck).

Fig. 1

Fig. 2

Fig. 3

Fig. 4

Fig. 5

Fig. 6

Fig. 7

Fig. 8

Fig. 9

Fig. 10

Operation Mode 1        Operation Mode 2

Fig. 11

Fig.12

Fig. 13

Fig. 14

Fig. 15

Fig. 16

Fig. 17

Fig. 18

Fig. 19

Fig. 20

Fig. 21

Current through the electromagnet

Q1 and Q2 ON | Q1 and Q2 OFF | Q1 and Q2 OFF | Q1 and Q2 ON | Q1 and Q2 ON

Time

Fig. 22

A-A                                    B-B

Fig. 23

A-A                                    B-B

Fig. 24

A-A

B-B

5

B

4

4

B

8

8

A

A

Fig. 25

A-A

B-B

5

B

4

4

B

8

8

A

A

Fig. 26

Fig. 27

Fig. 28

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015014853 A1

- US 2014216057 A1